Europäisches Patentamt

European Patent Office

Office européen des brevets

(11) Publication number: **0 090 050**
**A1**

# EUROPEAN PATENT APPLICATION

published in accordance with Art. 158(3) EPC

(21) Application number: 82902829.9

(22) Date of filing: 22.09.82

Data of the international application taken as a basis:

(86) International application number:
**PCT/JP 82/00383**

(87) International publication number:
**WO 83/01173 (31.03.83 83/8)**

(51) Int. Cl.³: **H 05 K 3/30, H 05 K 13/02**

(30) Priority: 25.09.81 JP 152780/81

(43) Date of publication of application: 05.10.83
**Bulletin 83/40**

(84) Designated Contracting States: **DE FR GB NL**

(71) Applicant: **Matsushita Electric Industrial Co., Ltd., 1006, Oaza Kadoma, Kadoma-shi Osaka-fu, 571 (JP)**

(72) Inventor: **NARIKIYO, Kazuhiko, 5-104, Ikuno 4-chome Katano-shi, Osaka-fu 576 (JP)**
Inventor: **MAEDA, Yoshinobu, 15-17, Myokenzaka 3-chome Katano-shi, Osaka-fu 576 (JP)**
Inventor: **YAMAGAMI, Akio, 36-5, Yamadaike higashimachi Hirakata-shi, Osaka-fu 573-01 (JP)**

(74) Representative: **Crawford, Andrew Birkby et al, A.A. THORNTON & CO. Northumberland House 303-306 High Holborn, London WC1V 7LE (GB)**

(54) **DEVICE FOR INSERTING ELECTRIC PART.**

(57) A device for inserting electric parts, which has a strip part assembly (6) in which a number of electric parts (3) with lead wires (2a, 2b) disposed in the same direction are arranged at equal intervals, means (1) for supplying the assembly (6) in an attitude in which the lead wires are disposed downward, means (91) for interposing an electric part between a pair of chuck jaws (90) moving parallel to each other, and an insertion guide (100) disposed in the direction of the lead wires which are to be inserted into a printed board (13), for guiding the lead wires of the electric part. The interval between an electric part (203) already inserted into the printed board and an electric part (3) which is to be inserted next can be set to a small distance, thereby enabling the insertion of electric parts in a high density.

SPECIFICATION

TITLE MODIFIED
see front page?

TITLE OF THE INVENTION

Electronic Component Inserting Apparatus

TECHNICAL FIELD

This invention relates to an electronic component inserting apparatus which holds the lead wires of an electronic component by a pair of chuck pawls and isnerts the lead wires into holes formed in a printed circuit board, and more particularly to a component inserting apparatus adapted to provide a high inserting density by ensuring that the component being inserted will not contact the components already inserted and be inserted with the minimum spacing therefrom.

BACKGROUND OF THE INVENTION

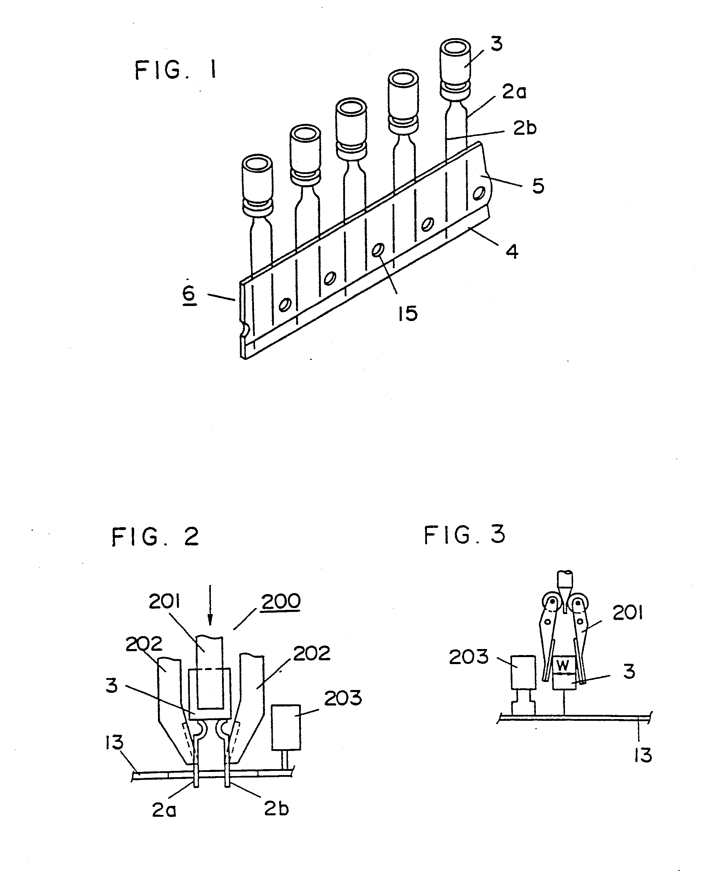

A conventional electronic component inserting apparatus of this type is illustrated in Figs. 2 and 3. Many electronic components to be mounted by the apparatus on a printed circuit board have their lead wires 2a, 2b extending in the same direction and are disposed at uniform spacing intervals on a flexible base tape 4 such as a paper tape and secured in position by another tape 5, thereby forming a band-like group of components 6 (also called

"taped components"), as illustrated in Fig. 1.  Such a component inserting apparatus comprises a tape feed unit for supplying electronic components one by one, a unit moving body for carrying the feed tape unit and moving to predetermined positions, a cutter unit for severing each of the components to be inserted and gripping it and transporting it to an insertion head unit, and the insertion head unit for holding by a chuck unit 200 the main part of the component transported by the cutter unit and bringing it to a point above a printed circuit board and inserting the lead wires along a guide piece into holes.

The chuck unit 200 holds an electronic component 3 by rotating chuck pawls 201 about respective pivots, so that one chuck pawl may contact the component 3 at a line and the other chuck pawl may contact the component at a point.  As a result, the direction of the lead wires 2a, 2b of the component 3 held by the chuck pawls is not fixed but varies depending on the width W of the component 3 or the kinds of components.  Hence, it has been required to place two guide pieces 202 in parallel with a plane in which the lead wires 2a, 2b are disposed and to insert the lead wires 2a, 2b by making the spacing interval between the lead wires 2a, 2b a little longer than the spacing interval between the insertion holes and then adjusting the direction of the lead wires 2a, 2b.  Thus, the desnsity of the electronic components mounted on the printed circuit board is low. The greater the width of an electronic component becomes, the longer the interval between the ends of the chuck pawls becomes. The insertion guides 202 are also large compared with the electronic component 3 and wtih the spacing interval between the lead wires 2a, 2b. Hence, it is very likely that the insertion guide contacts the electronic components having already been mounted. Consequently, the conventional apparatus has also such a drawback that the spacing between the electronic component 203 having already been mounted and a component 3 that it newly mounted must be made long, thus decreasing the number of the components that can be mounted on a printed circuit board. Further, since the conventional apparatus includes a plurality of tape feed units for intermittently feeding electronic components horizontally, the unit moving body must move over a long distance so that the large space for installing the apparatus must be provided.

DISCLOSURE OF THE INVENTION

The apparatus according to this invention comprises means for supplying a band-like group of components which is formed by disposing a plurality of electronic components extending their lead wires in the same direction at uniform spacing intervals with the lead wires directed downward, means for holding each electronic component by moving a pair of the chuck pawls in parallel with each other, and an inserting guide for guiding a lead wire, which is placed in parallel with the arranged lead wires to be inserted into holes in a printed circuit board, whereby shortening the spacing interval between the electronic components mounted on the printed circuit board, and thus making a high density of components to be inserted possible.

BRIEF DESCRIPTION OF THE DRAWINGS

Fig. 1 is a perspective view of a band-like group of the components to be inserted by an electronic component insertion apparatus according to this invention;

Fig. 2 is a front view of the insertion guide of the chuck unit in a conventional component insertion apparatus;

Fig. 3 is a front view of the chuck unit when a component is inserted into holes;

Fig. 4 is a general perspective view of a component inserting apparatus according to an embodiment of this invention;

Fig. 5 is an enlarged view of a part of the apparatus according to this invention;

Fig. 6 is a perspective view of a tape feed unit;

Fig. 7 is a horizontal sectional view of the tape feed unit;

Fig. 8 is a sectional view of a tape feed unit moving body;

Fig. 9 is a perspective view of a tape supply unit;

Fig. 10 is a sectional view of the tape feed unit and insertion head unit;

Fig. 11 is a perspective view of a component severing unit;

Fig. 12 is a perspective view of the main part of the component severing unit;

Fig. 13 is a perspective view of the insertion head;

Fig. 14 is a perspective view of a component transport unit with a part being sectioned;

Fig. 15 is a horizontal sectional view of the chuck unit in the component transport unit;

Fig. 16 is a vertical sectional view of the chuck unit of the insertion head unit;

Fig. 17 is a vertical sectional view of the insertion guide unit in the insertion head unit;

Fig. 18 is a perspective view of the insertion head unit;

Figs. 19 through 24 and Figs. 26 through 28 are sectional views of the insertion guide unit in the insertion head unit when a component is held by the chuck and is inserted by the inserting guide;

Fig. 25 is a perspective view of the main part of the insertion guide unit;

Fig. 29 is a plan view of an insertion head driving unit;

Fig. 30 is a perspective view of a board moving unit.


BEST MODE FOR CARRYING OUT THE INVENTION

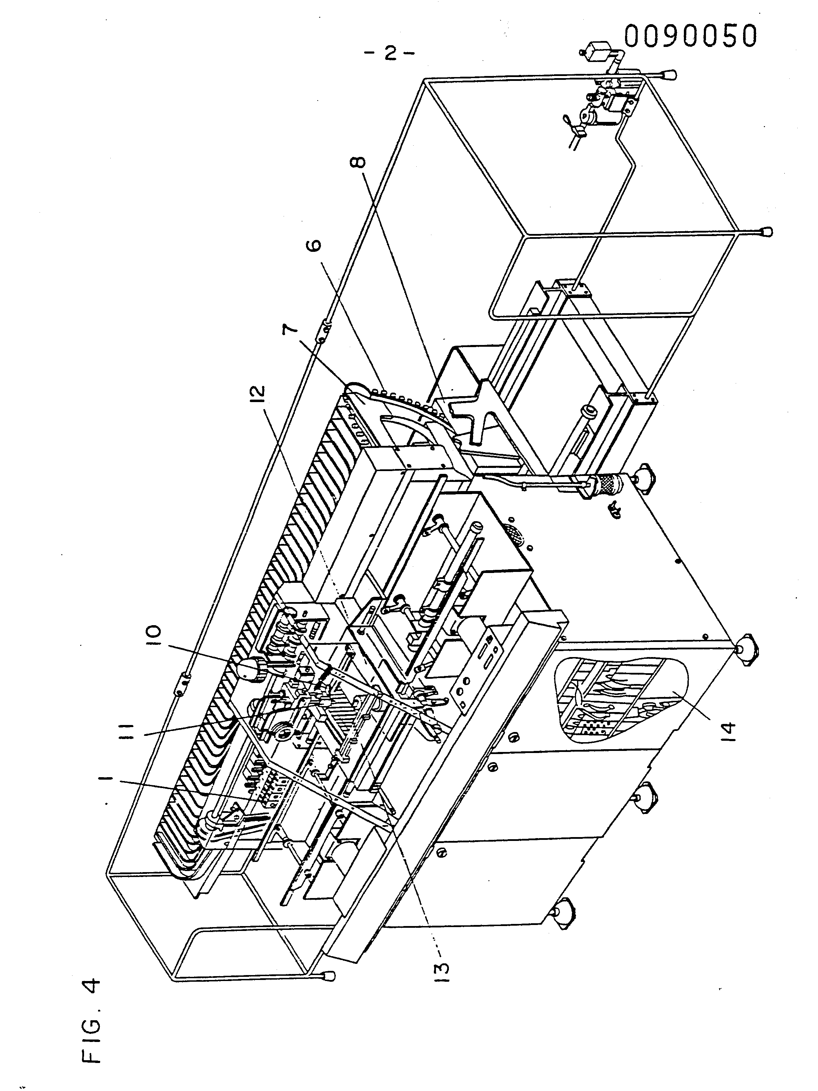

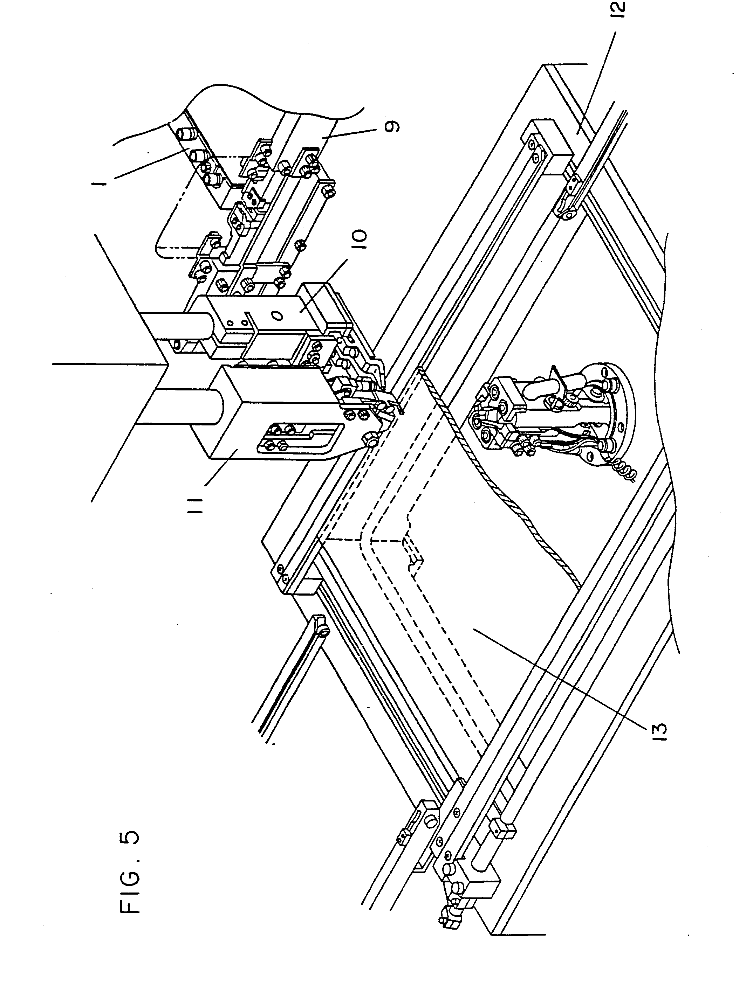

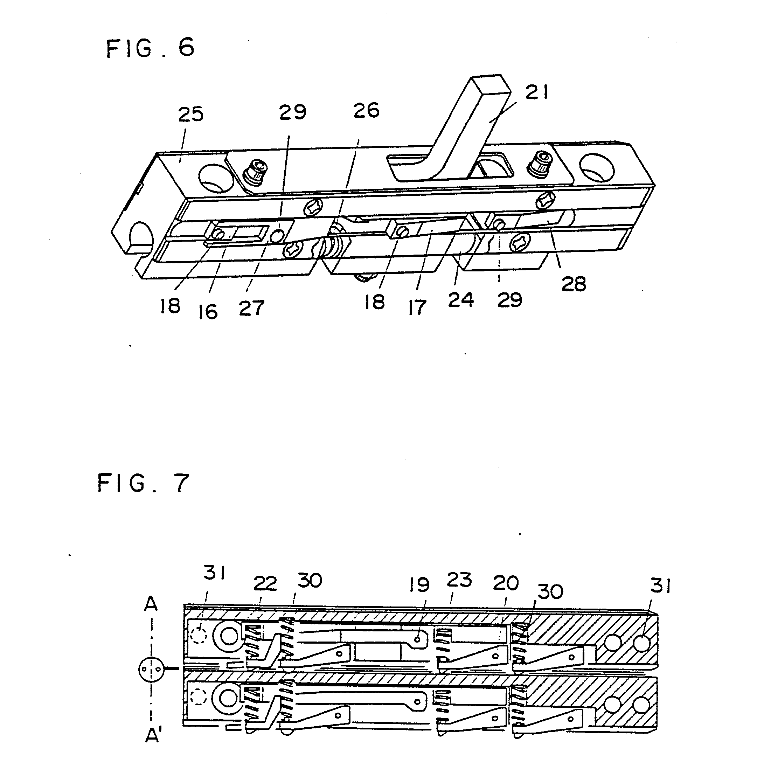

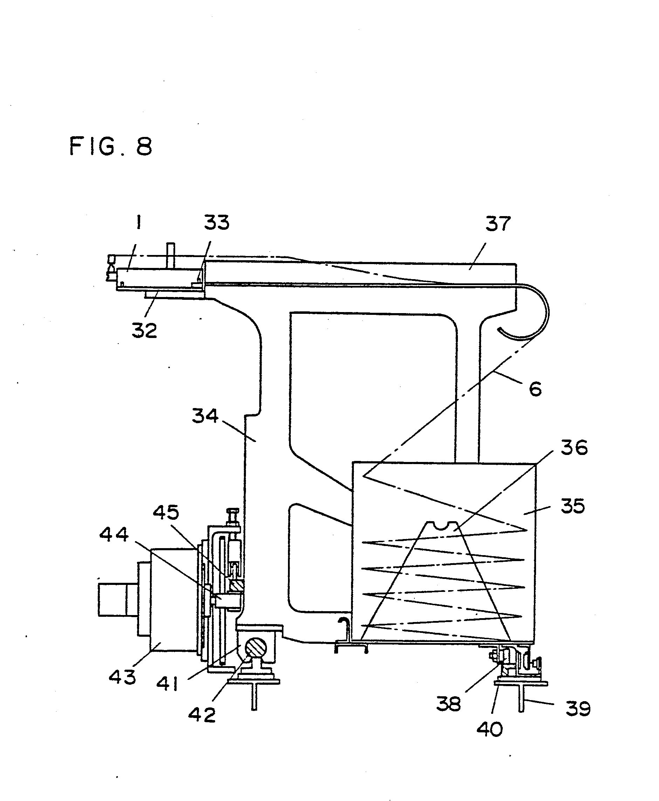

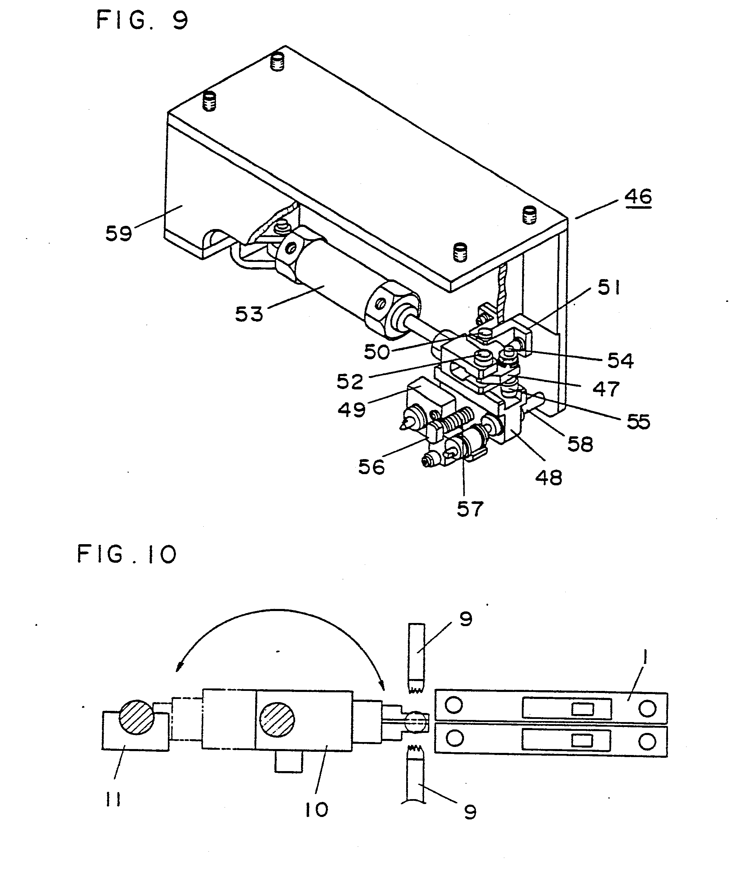

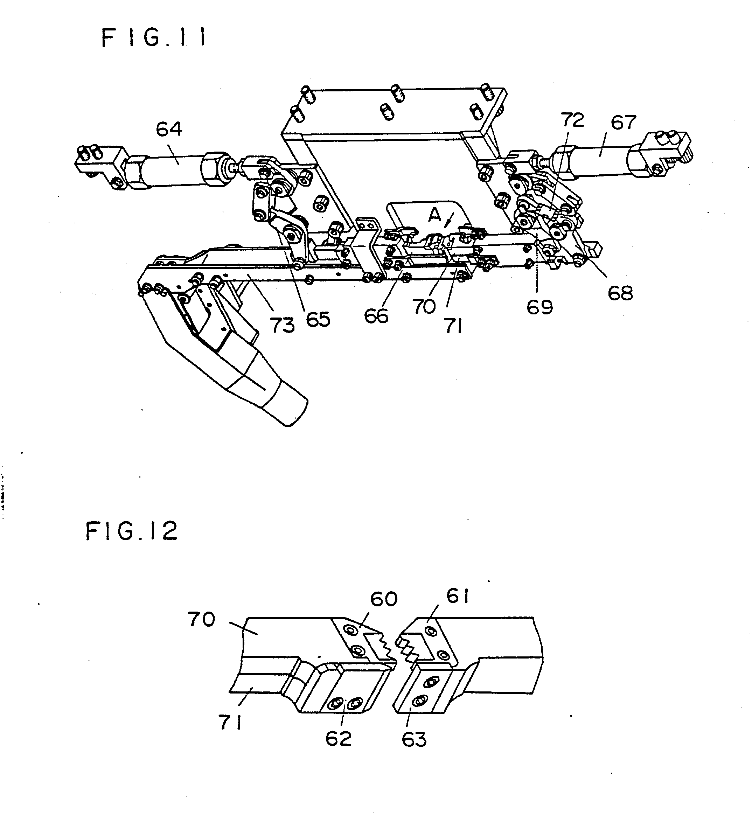

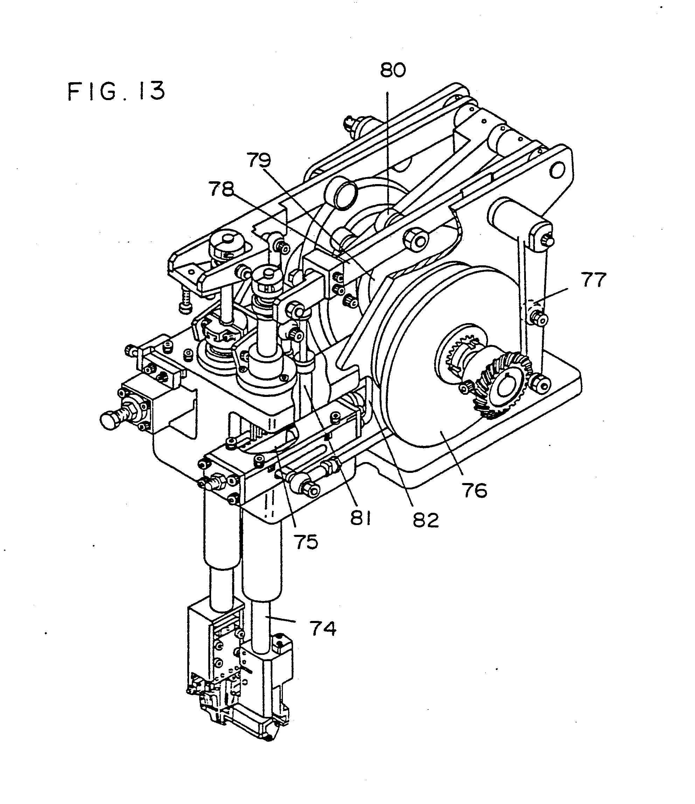

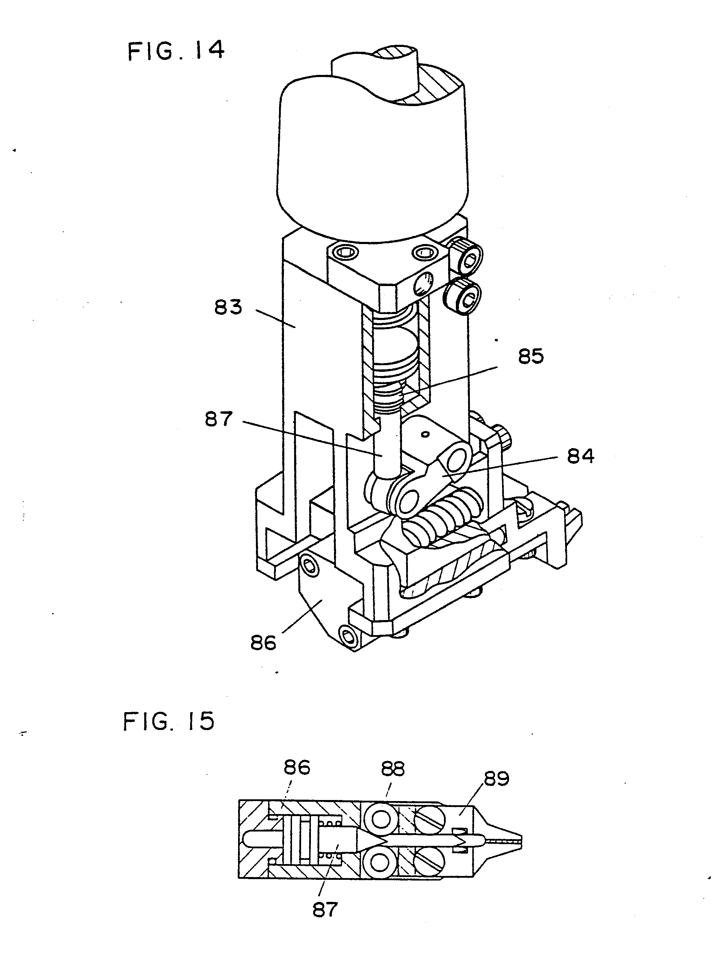

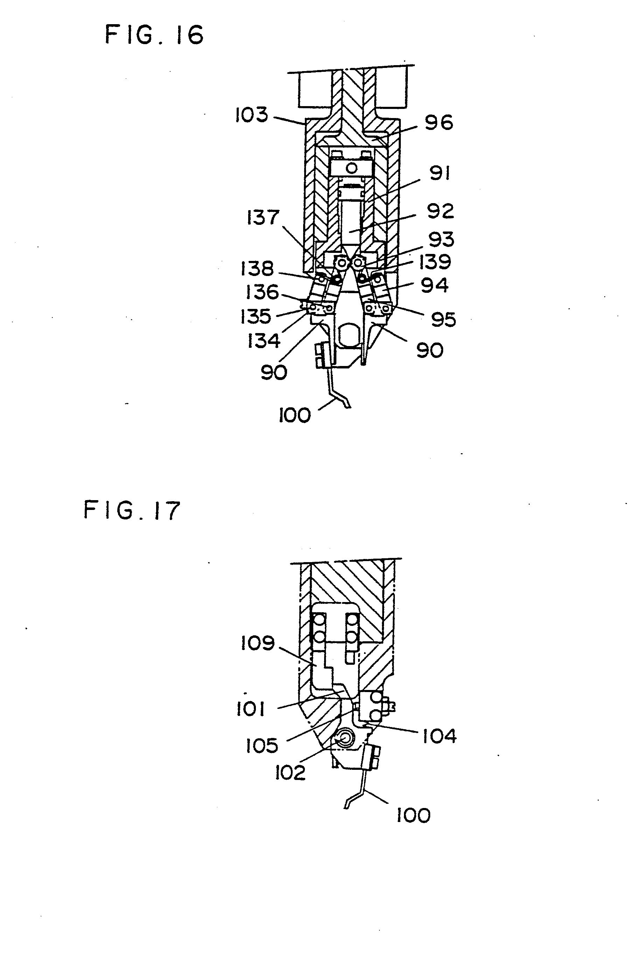

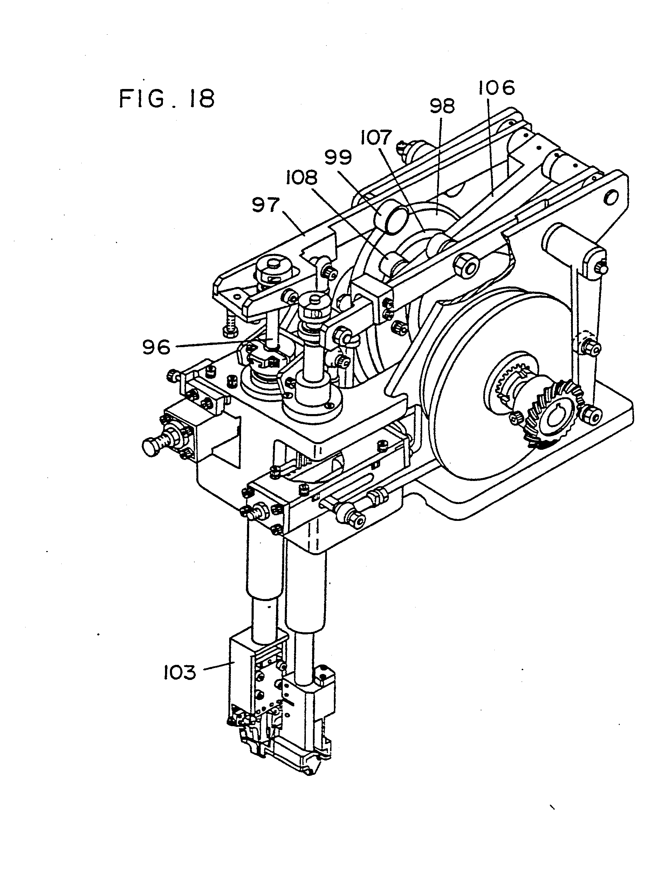

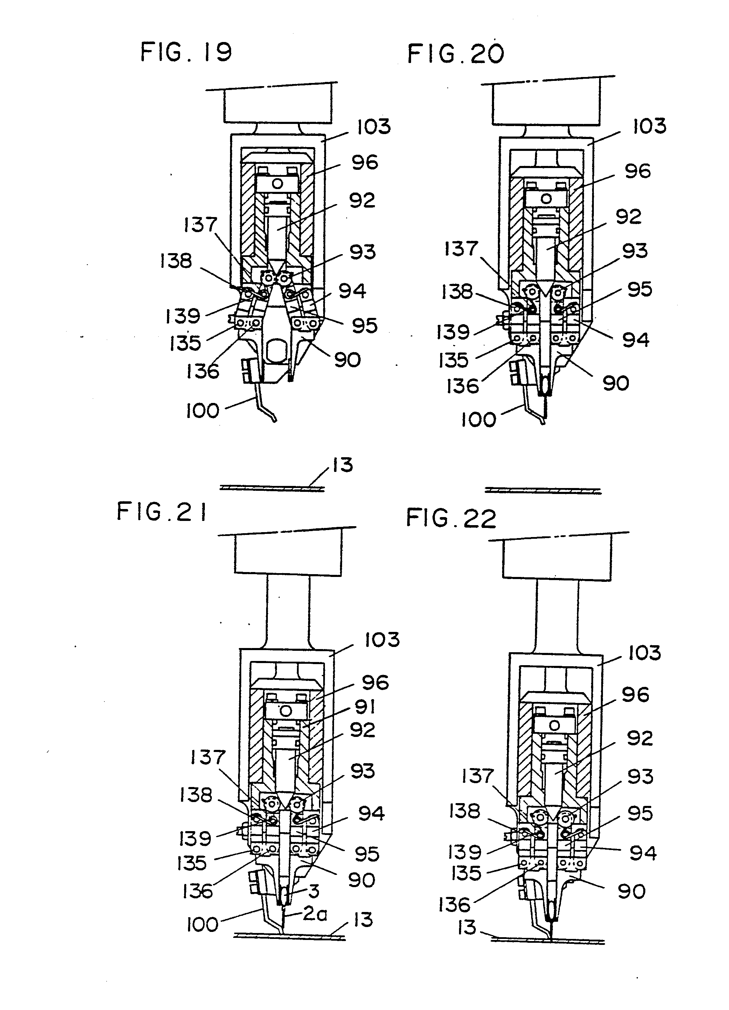

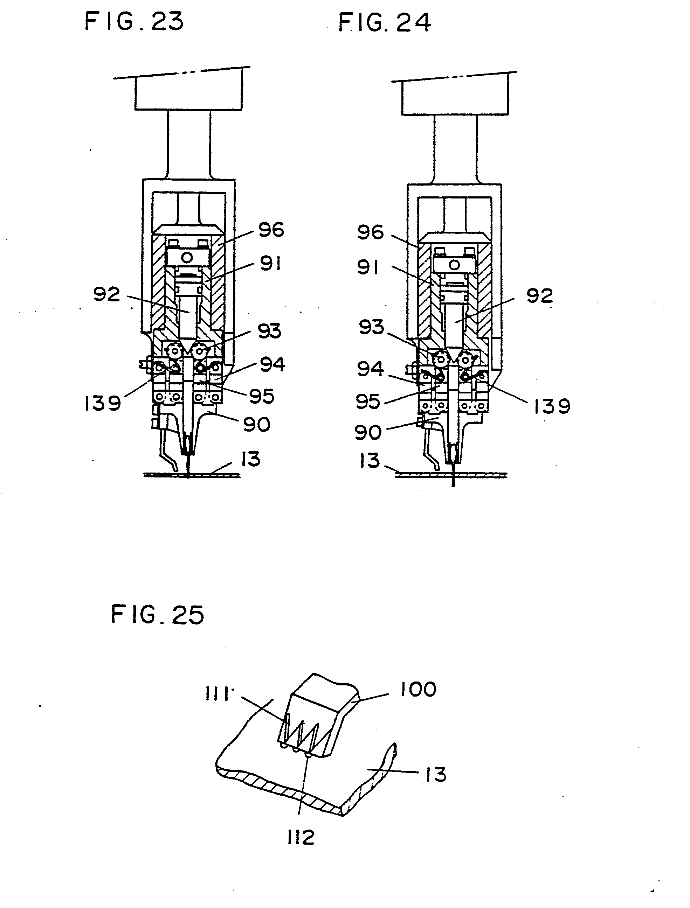

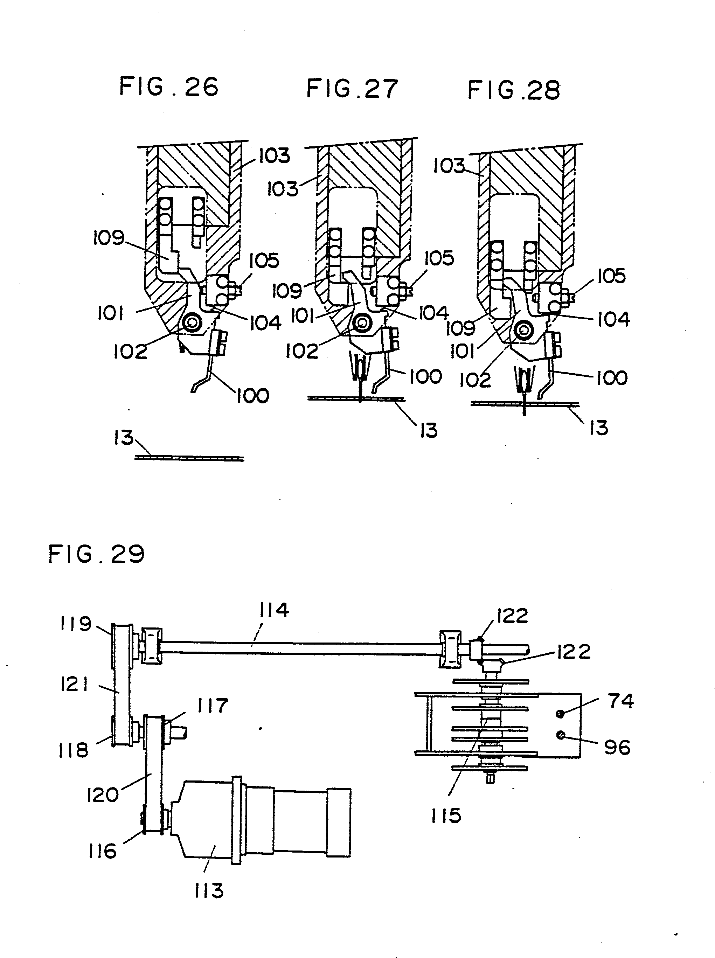

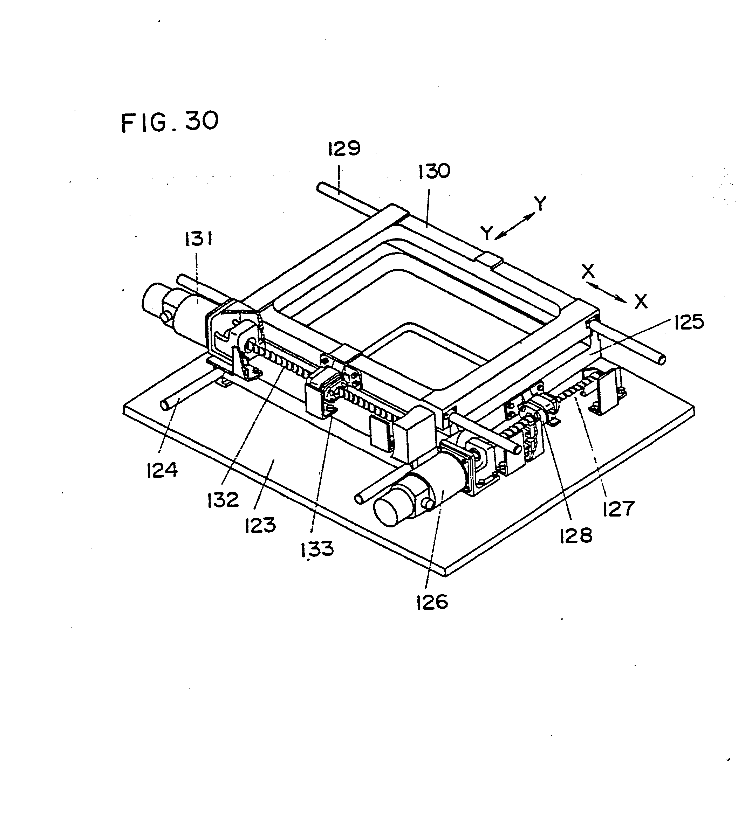

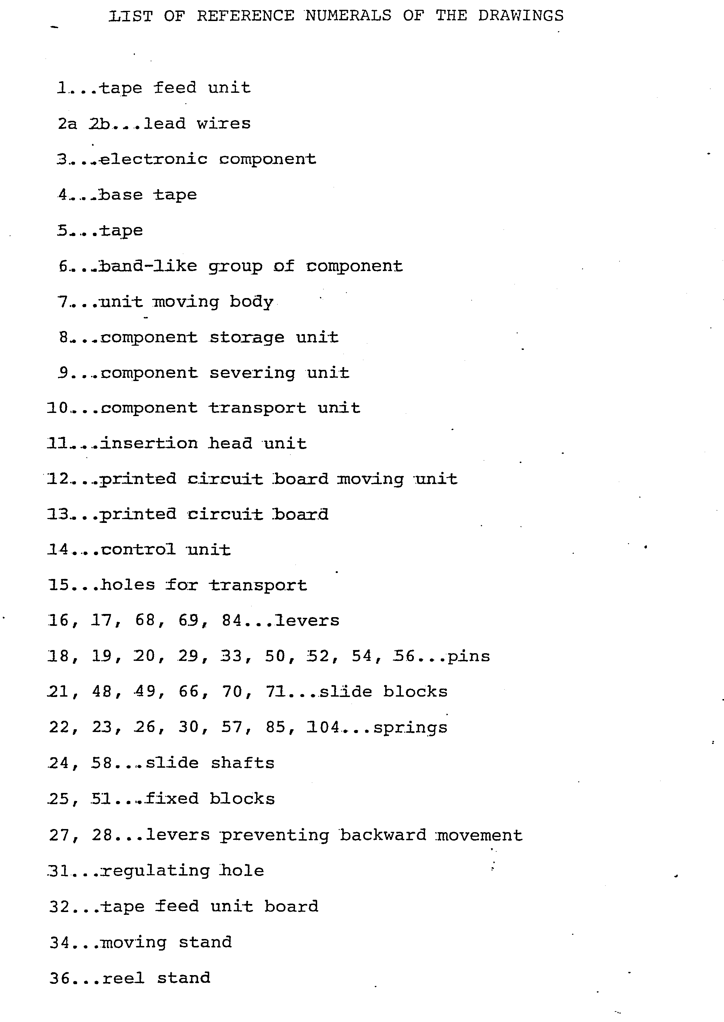

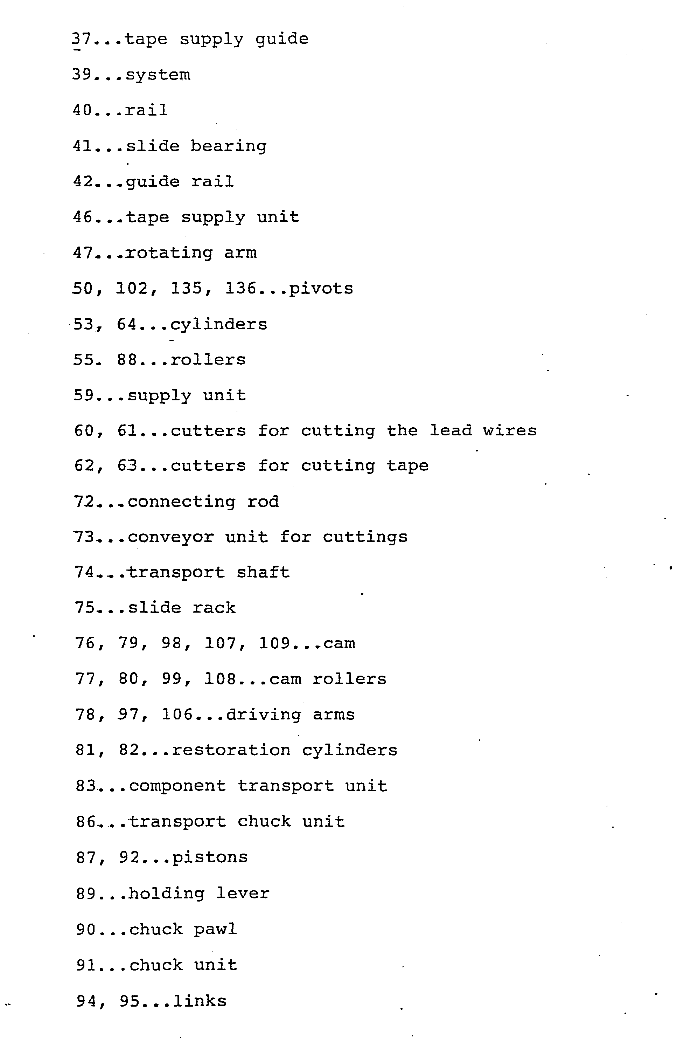

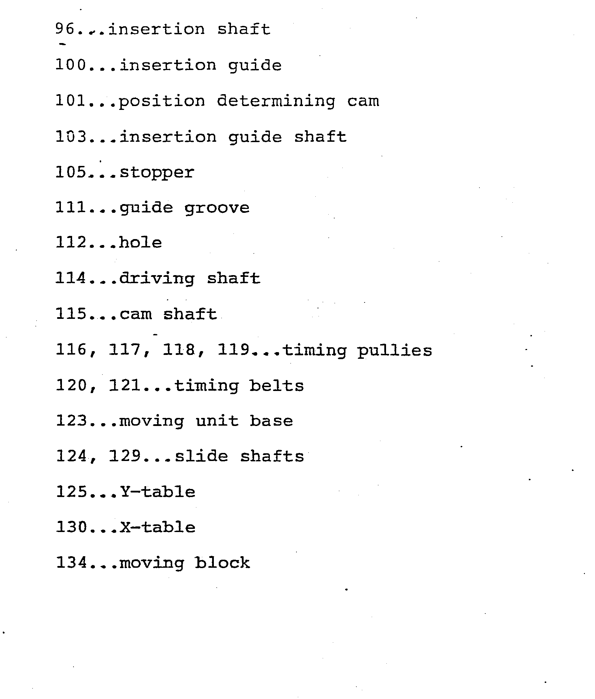

Hereinafter an embodiment according to this invention will be explained with reference to Fig. 1 and Figs. 4 through 30.

Numeral 1 is a tape feed unit for loading a band-like group of components 6. Numeral 7 is a unit moving body which carries a plurality of the tape feed units 1 and a corresponding plurality of component storage units 8 disposed behind the tape feed units, and moves rightward or leftward to bring a given tape feed unit 1 to a predetermined component take-up position. Numeral 9 is a component severing unit for cutting the leed wires 2a, 2b of the components and for severing them from the tapes 4, 5 and for taking away the tapes at a predetermined component take-up position. Numeral 10 is a component transport unit for holding the lead wires 2a, 2b of the components severed at the component severing uint 90 and for transporting them to an insertion head unit 11.
Numeral 12 is a printed circuit board moving unit for
holding a printed circuit board 13 which has been set
in place and for moving forward, backward, leftward or
rightward to appropriately position the printed
circuit board for the insertion of a component.
Numeral 14 is a control unit for controlling the unit
moving body 7, the component severing unit 9, the
printed circuit board moving unit 12 and the inserting
operation by the insertion head unit 11.

Firstly, the tape feed unit will be explained.

As illustrated in Fig. 1, the lead wires 2a, 2b
of electronic components 3 which extend in the same
direction are held by band-like mount paper 4 and tape
5 therebetween at uniform spacing intervals, and holes
for a transport purpose are formed therein also at
uniform spacing intervals, thereby forming taped
components.

Numerals 16 and 17 are levers for transporting
the taped components. At the end portions of the
respective levers are fixed columnar pins 18 which are
slantwise cut at an appropriate height. The levers 16
and 17 are connected by pis 19 and 20 respectively to
a slide block 21, and are pushed upward by springs 22
and 23 to a transporting surface. The slide block 21
which is fixedly connected to a slide shaft 24 and is
connected to a fixed block 25 through a spring 26, slide reciprocally. The fixed block 25 on which levers 27 and 28 preventing backward movement are fixed by pins, is provided with a spring 30 pushing it to the transporting surface. At the end portions of each of the levers 27 and 28 are fixed pins 29 having spherical surfaces.

With the above arrangement, the slide block 21 is slid reciprocally to make the levers 16 and 17 feed the taped components step by step by the spacing interval, so that each component is transported to a supply line A-A'. The tape feed unit 1 has regulating holes 31 in the fixed block 25 so that the tape feed unit is easily set in place in the board (hereinafter explained) and removed therefrom.

Next, the tape feed unit moving body 7 will be explained.

As aforementioned, a plurality of the tape feed units 1 are set in place by pins 33 on a common tape feed unit board 32. In a moving stand 34 holding the board 32, boxes 35 storing the taped components are maintained in a reel stand 36, with the number of the boxes 35 corresponding to that of a pair of the tape feed units 1. From each of the storing boxes 35, the band-like taped components 6 are supplied to the tape feed unit 1, with the taped components being vertically regulated by a tape supply guide 37. The moving stand 34 is supported at one end of its lower portions by a rail 40 through a plurality of rollers 38, the rail 40 being incorporated in the main part of a system 39 in parallel with the board 32, and is supported at the other end of its lower portions by a guide rail 42 through a slide bearing 41. Numeral 43 is a driving motor for the tape feed unit moving body 7. Numeral 44 is a pinion gear. Numeral 45 is a rack gear meshed with the pinion gear 44, and is fixed on the moving stand 34. The taped components 6 and the tape feed unit 1 selected by the rotational control performed by the driving motor 43 are moved to the front side of the insertion head 11 as desired. The components fed from the tape feed unit 1 selected by the tape feed unit moving body are sent one by one by a tape supply unit 46. The tape supply unit 46 makes slide blocks 48, 49 slide by the movement of a rotating arm 47, thereby supplying the taped components 6 to a position where the components are severed and transported. The rotating arm 47 is connected to a fixed block 51 by a pivot pin 50 which is freely movable and is connected to a cylinder 53 by a pin 52. The slide blocks 48 and 49 are made to contact to a roller 55 which is connected by a pin 54 and are slid by the cylinder 53.

The slide blocks 48 and 49 are biasedly connected by a pin 56 and a spring 57, which are fixedly connected to a supply unit 59 via a slide shaft 58.

The components to be inserted are severed one after another from the band-like taped components by the component severing unit (hereinafter explained) and are tarnsported to the chuck of the insertion head unit 11 by the component transporting unit (hereinafter explained) and are inserted into desired holes in the printed circuit board 13 after being regrasped. Each of the taped components 6 fed along the tape feed unit 1 is held by the component transport unit 10 and is severed by the component severing unit 9 and is rotated by 180° by the component transport unit 10 with a horizontal and upward and downward movements, and is regrasped by the insertion head unit 11. Thereafter, the insertion head unit 11 is lowered to insert the component into desired holes. The component severing unit 9 is provided with cutters 60 and 61 for cutting the lead wires and with cutters 62 and 63 for cutting the tapes. A cylinder 64 rotates a lever 65 to slide a slide block 66. On the slide block 66 are fixed the cutter 61 for cutting the lead wires and the cutter 63 for cutting the tapes. A cylinder 67 also rotates levers 68 and 69 thereby sliding slide blocks 70 and 71. The slide block 70 fixedly holds the other cutter 60 for cutting the lead wires, while the slide block 71 fixedly holds the cutter 62 for cutting the tapes.

Between the levers 68 and 69, a connecting rod 72 is provided to adjust the positions thereof. It should be noted that the lead wire cutters 60 and 61 hold, cut and shape the lead wires with their complementary blades. The tape cuttings are brought to by a conveyor unit 73 and put into a waste box installed in the main part of the system.

Numeral 74 is a transport shaft for rotating, raising and lowering the component transport unit 10. Numeral 75 is a slide rack for rotating the transport shaft 74. The rotation of a cam 76 causes the transport shaft to rotate through a cam roller 77. A driving arm 78 connected to the upper portion of the transport shaft is driven in response to the rotation of a cam 79 to raise and lower the transport shaft 79 through a cam roller 80. Numerals 81 and 82 are cylinders for restoring the slide rack 75 and the driving arm 78 respectively to the original positions. Numeral 83 is the main part of the component transport unit constituting a cylinder unit, which is connected to the main part of a transport chuck unit 86 through a lever 84 having a roller and a spring 85, and is caused to be slid back and forth by the movement of a piston 87. Numeral 86 is the main part of the transport chuck unit constituting the cylinder unit, and contains the piston 87 with a cone shape at its end and a pair of holding levers 89 having rollers 88 contacting the surface of the cone shaped piston. The operation of the piston 87 causes the pair of the levers 89 to hold the lead wires 2a, 2b.

Next, the component transported by the component transport unit 10 is held by a pair of the chuck pawls 90 holding the main part of the component. Numeral 91 denotes the main part of the chuck unit constituting a cylinder, and contains a piston 92 with its end portion being formed in the shape of a cone. The piston 92 causes movable links 94 and 95 to move through rollers 93 contacting the surface of the cone shape of the piston so that a pair of chuck pawls 90 move in parallel with each other and thus hold the main part of the component. The main part of the chuck unit 91 is fixed to an insertion shaft 96 which moves upwards and downwards. A driving arm 97 is connected to the end portion of the insertion shaft. Rotation of a cam 98 causes the insertion shaft 96 to be raised or lowered via a cam roller. It should be noted that the insertion shaft 96 is journaled in a hole formed inside of a insertion guide shaft 103.

Next, the construction of the chuck pawl 90 holding an electronic component will be explained in detail.

A pair of chuck pawls 90 holding an electric component 3 are fixed on movable blocks 134 which are supported by two pivot pins 135 and 136. The pivot pins 135 and 136 support a small link 94 and a large link 95 respectively. The large link 95 is biased toward the center about a pivot pin 137 by a torsion spring 139, thereby making the roller 93 contact the piston 92 which is journaled in the chuck unit, with the end portion of the piston being shaped in a cone form. The operation of the piston 92 causes the large link 95 to move about the pivot pin 137 through the roller 93. At the same time the small link follows. With the aforementioned arrangement, a pair of the chuck pawls move in parallel with respect to the center of the electronic component 3 and hold it. Numeral 100 is an inserting guide for guiding the lead wires 2a, 2b, and is fixed on a position determining cam 101 in parallel with a plane in which the lead wires are maintained. The position determining cam 101 is fixed on an insertion guide shaft 103 by a pivot pin 102, and is regulated by a spring 104 and a stopper 105. The insertion guide shaft 103 is connected to a driving arm 106 at its upper portion. The rotation of a cam roller 107 causes the insertion guide shaft 103 to be raised or lowered through a cam roller 108.

Next, the operation of the insertion part will be explained in detail. The inserting guide 100 is regulated in position by a position regulating cam 101 and a cam 109, thereby maintaining holes 112 of the printed circuit board 13 and corresponding guide grooves 111 at the same points. When the insertion shaft 96 is lowered, the lead wires 2a, 2b of an electronic component are moved along the guide grooves 111 and are inserted into the holes 112 of the printed circuit board 13. When the lead wires are pushed out beneath the printed circuit board 13 by a little distance, the inseting guide 100 is raised a little amount so that the position regulating cam 101 is released from the cam 109. Thereafter, the insertion shaft 96 is further lowered and the cam 109 combined with the insertion shaft 96 causes the inserting guide 100 to open so that the electronic component 3 is inserted up to a predetermined position. On completion of the inserting operation, the lead wires 2a, 2b are fixed to the underside of the printed circuit board 13. Then the chuck pawls are released, and the insertion shaft 96 and the guide shaft 103 are raised to their original positions.

Accordingly, because an electronic component 3 is held by the parallel holding force of the chuck pawls, the holding state is not affected by different sizes of the electronic components, thus eliminating the problem that the direction of the lead wires is varied with respect to the inserting direction of the electronic component. Further, the driving of the insertion head unit will be explained.

Numeral 113 denotes a motor with a clutch brake, and is mounted on the main part of the system 39.

Indicated at 114 is a driving shaft which is journaled in the main part of the system.  Numeral 115 represents a cam shaft for rocking the transport unit 10 and the insertion head unit 11, with both ends of the cam shaft being journaled in the main part of the insertion head unit.  The output shaft of the motor is connected to the driving shaft 114 through timing pulleys 116, 117, 118 and 119 and timing belts 120 and 121.  The driving shaft 114 is connected to the cam shaft 115 by a pair of meshing gears 122.

With the above arrangement, the rotation of the cam shaft 115 causes the component transport unit 10 to make upward, downward and rotational movements, and causes the insertion head unit to operate, thereby performing an inserting operation.

Next, the printed circuit board moving unit 12 will be explained.  Numeral 123 is a moving unit base which supports the printed circuit board moving unit 12 on the system 39.  Numeral 124 is a Y-direction slide shaft which is fixedly mounted on the moving unit base 123.  Numeral 125 is a Y-table and slides on the slide shaft 124.  Numeral 126 is a motor which is mounted on the base 123.  Numerals 127 and 128 are a male ball screw and a ball nut respectively for driving the Y-table, and are directly connected to the motor 126, and are fixed to the Y-table. Similarly, numeral 129 is a slide shaft fixedly mounted on the Y-table 125. Numeral 130 is a X-table, and slides on the slide shaft 129. Numeral 131 is a motor which is mounted on the Yptable 125. Numerals 132 and 133 are a male ball screw and a ball nut respectively for driving the X-table, and are directly connected to the motor 131, and are fixed on the X-table 130.

INDUSTRIAL APPLICABILITY

This invention holds an electronic component by the parallel holding performed by the chuck pawls. This makes the attitude of a supplied component be kept constant regardless of various kinds and sizes of the electronic components supplied, and thus the direction variation of the lead wires with respect to the inserting direction of the electronic component can be eliminated.

Further, one insertion guide can be disposed in parallel with a plane in which the lead wires are arranged. This does not require us to consider various kinds of opening gaps between the chuck palws depending on kinds of the electronic components and the two directions of the insertion guide. This arrangement makes an extremely high inserting density of electronic components by planting electronic components on the parts of the printed circuit board where the widths of the chuck pawls and the isnertion guide do not exist.

Further, electronic components are supplied with the components being vertically maintained, the distance moved by the unit moving body is short, thus increasing productivity per an area unit.

CLAIMS:

1. An electronic component inserting apparatus comprising,

a tape feed unit for intermittently transporting a band-like group of the electronic components which is formed by disposing and fixing on tape a plurality of components extending their lead wires in the same direction at uniform spacing intervals with the lead wires directed downward,

a component severing unit for severing by cutting the lead wires and tapes each of the electronic components at a position where the component is taken out by the tape feed unit and is maintained thereat,

a component transport unit which holds the lead wires of the electronic component severed by the component severing unit and which is capable of rotating about a single pivot and of moving upwards or downwards,

an insertion head unit including holding members for receiving the electronic component from the component transport unit and holding the component by moving a pair of chuck pawls in parallel with each other and a guide member being placed in parallel with a plane in which the lead wires are arranged, which guides the lead wires to be inserted into the holes formed in a printed circuit board,

an anvil unit for cutting and bending the lead wires of the electronic component, thereby fixing them on the printed circuit board, and

a printed circuit board moving unit for supporting the printed circuit board and moving it horizontally.

2. An electronic component inserting apparatus as defined in Claim 1 wherein the tape feed unit comprises,

a transport lever fixedly provided with the first columnar pin which is capable of being inserted into the transport holes formed in the tape at uniform spacing intervals, the transport lever being connected to a reciprocally movable slide block, and

a return prevention lever provided with the second pin having a semispherical surface at its end, which is capable of being inserted into holes in the tape, with the transport lever and the return prevention lever being alternately connected to a fixed block,

the end portion of the first pin having an inclined surface so that the band-like group of components can be intermittently transported by a distance by the reciprocal sliding movement of the slide block and the pin can be seceded from the transport holes.

3. An electronic component inserting apparatus as defined in Claim 1 wherein the insertion head unit

0090050

comprises,

an insertion guide shaft being supported in such a manner that it can be moved upwards and downwards,

an insertion shaft which is capable of being freely slid relative to the insertion guide shaft and is movable upwards and downwards,

a pair of holding members for holding the electronic component, which are mounted on the end portion of the insertion shaft and can be rotated about respective pivots in response to the upward or downward movements of a piston,

an insertion guide unit which is mounted on the end portion of the insertion guide shaft and can be rotated in response to the relative motion by the insertion guide shaft and the insertion shaft through a cam, and is placed in parallel with a plane in which the lead wires of the electronic components are arranged and on one side of the lead wires, and has a groove for guiding a lead wire into a hole.

4. An electronic component inserting apparatus as defined in Claim 1 or 3 wherein the insertion guide unit has V-shaped grooves, the end portions of which being spaced by a spacing interval equivalent to the gap between the lead wires to be inserted.

5. An electronic component inserting apparatus as defined in Claim 1 or 3 wherein the holding members comprise,

a pair of chuck pawls for holding the electronic component,

two movable blocks for retaining the respective chuck pawls,

two pins disposed substantially horizontally in each of the movable blocks,

two pairs of parallel links one ends of which are supported by the two pins and the other ends of which are supported by two fixed pins which are disposed substantially horizontally and are spaced by the same spacing interval as that of said two pins, and

a member having a wedge shaped portion which is contacted by two rollers which are positioned close to each other and are mounted on bodies which are combined with one links of the respective pairs of links and which are placed in the opposite side of the parallel links with respect to the fixed pins,

whereby a sliding motion of said wedge shaped member increases the spacing interval between the two rollers to thereby rotate said parallel links about said fixed pins.

6. An electronic component inserting apparatus as defined in Claim 1 wherein the component severing unit comprises

a pair of cutters for cutting the lead wires of the electronic components,

a pair of cutters for cutting the tapes, which is

0090050

disposed at a right angle with the lead wire cutter,

with one blade of the lead wire cutter being shaped in a convex form and the other blade thereof being shaped in a concave form,

with the lead wires being guided to be inserted into the holes,

with one blade of the tape cutter being formed in a plane form and the other blade thereof being shaped in a convex form and the tape being cut by a press force exerted thereto by the two blades.

FIG. 1

FIG. 2

FIG. 3

FIG. 4

FIG. 5

- 3 -

0090050

FIG. 6

FIG. 7

FIG. 8

FIG. 9

FIG. 10

FIG.11

FIG.12

FIG. 13

0090050

FIG. 14

83

85

87

84

86

FIG. 15

86          88          89

87

FIG. 16

FIG. 17

FIG. 18

FIG.19

FIG.20

FIG.21

FIG.22

FIG. 23

FIG. 24

FIG. 25

FIG.26     FIG.27     FIG.28

FIG.29

FIG. 30

0090050

LIST OF REFERENCE NUMERALS OF THE DRAWINGS

1...tape feed unit

2a 2b...lead wires

3...electronic component

4...base tape

5...tape

6...band-like group of component

7...unit moving body

8...component storage unit

9...component severing unit

10...component transport unit

11...insertion head unit

12...printed circuit board moving unit

13...printed circuit board

14...control unit

15...holes for transport

16, 17, 68, 69, 84...levers

18, 19, 20, 29, 33, 50, 52, 54, 56...pins

21, 48, 49, 66, 70, 71...slide blocks

22, 23, 26, 30, 57, 85, 104...springs

24, 58...slide shafts

25, 51...fixed blocks

27, 28...levers preventing backward movement

31...regulating hole

32...tape feed unit board

34...moving stand

36...reel stand

37...tape supply guide

39...system

40...rail

41...slide bearing

42...guide rail

46...tape supply unit

47...rotating arm

50, 102, 135, 136...pivots

53, 64...cylinders

55. 88...rollers

59...supply unit

60, 61...cutters for cutting the lead wires

62, 63...cutters for cutting tape

72...connecting rod

73...conveyor unit for cuttings

74...transport shaft

75...slide rack

76, 79, 98, 107, 109...cam

77, 80, 99, 108...cam rollers

78, 97, 106...driving arms

81, 82...restoration cylinders

83...component transport unit

86...transport chuck unit

87, 92...pistons

89...holding lever

90...chuck pawl

91...chuck unit

94, 95...links

- *18*    0090050

96...insertion shaft

100...insertion guide

101...position determining cam

103...insertion guide shaft

105...stopper

111...guide groove

112...hole

114...driving shaft

115...cam shaft

116, 117, 118, 119...timing pullies

120, 121...timing belts

123...moving unit base

124, 129...slide shafts

125...Y-table

130...X-table

134...moving block

# INTERNATIONAL SEARCH REPORT

International Application No. PCT/JP82/00383

## I. CLASSIFICATION OF SUBJECT MATTER (if several classification symbols apply, indicate all) [3]

According to International Patent Classification (IPC) or to both National Classification and IPC

Int. Cl.[3] H05K 3/30, 13/02

## II. FIELDS SEARCHED

### Minimum Documentation Searched [4]

| Classification System | Classification Symbols |
|---|---|
| I P C | H05K 3/30, 13/00-13/04 |

| | Documentation Searched other than Minimum Documentation to the Extent that such Documents are Included in the Fields Searched [5] |
|---|---|
| | Jitsuyo Shinan Koho      1975 - 1982 |
| | Kokai Jitsuyo Shinan Koho      1975 - 1982 |

## III. DOCUMENTS CONSIDERED TO BE RELEVANT [14]

| Category* | Citation of Document, [16] with indication, where appropriate, of the relevant passages [17] | Relevant to Claim No. [18] |
|---|---|---|
| X | JP,A, 54-147476 (Hitachi, Ltd.) 17. November. 1979 (17.11.79) Page 368, column 2, lines 1 to 12, page 368, column 4, line 1 to page 369, column 1, line 3, page 372, column 4, lines 3 to 16, Figs. 3, 8, 9, 14(a), (b), 22 | 1 - 6 |

* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| December 20, 1982 (20.12.82) | December 27, 1982 (27.12.82) |

| International Searching Authority [1] | Signature of Authorized Officer [20] |
|---|---|
| Japanese Patent Office | |

Form PCT/ISA/210 (second sheet) (October 1981)